# FASCICULE DE BREVET EUROPEEN

(11) **EP 2 089 319 B1**
(45) Date de publication et mention de la délivrance du brevet: **31.07.2013**
(21) Numéro de dépôt: 07870238.8
(22) Date de dépôt: 02.11.2007
(51) Int. Cl.: C01B 33/037, C30B 11/14, C30B 29/06, H01L 31/18

(54) **PROCEDE DE PURIFICATION DE SILICIUM METALLURGIQUE PAR SOLIDIFICATION DIRIGEE**
VERFAHREN ZUR REINIGUNG VON METALLURGISCHEM SILICIUM DURCH GERICHTETE ERSTARRUNG
METHOD OF PURIFYING METALLURGICAL SILICON BY DIRECTIONAL SOLIDIFICATION

(30) Priorité: 02.11.2006 FR 0609584
(43) Date de publication de la demande: 19.08.2009
(73) Titulaire: Commissariat à l'Énergie Atomique et aux Énergies Alternatives, 75015 Paris (FR)
(72) Inventeur: SERVANT, Florence, 38000 Grenoble (FR); CAMEL, Denis, 73000 Chambéry (FR); DREVET, Béatrice, 38000 Grenoble (FR)
(74) Mandataire: Hecké, Gérard
(86) Numéro de dépôt international: PCT/FR2007/001818
(87) Numéro de publication internationale: WO 2008/065270

(56) Documents cités:
- EP-A- 0 887 442
- EP-A1- 0 748 884
- FR-A1- 2 853 913
- GB-A- 2 084 978

## Description

### Domaine technique de l'invention

L'invention est relative à un procédé de purification de silicium métallurgique par solidification dirigée pour obtenir un silicium de qualité solaire ou photovoltaïque.

### État de la technique

Les cellules photovoltaïques sont généralement réalisées à partir de silicium cristallisé. Les lingots de silicium utilisés ont majoritairement une structure multi-cristalline : ils sont constitués par des grains monocristallins non orientés, typiquement centimétriques, reliés entre eux par des joints de grains et résultant d'une croissance colonnaire. Leur croissance est réalisée dans un four de cristallisation, par exemple de type HEM (provenant du nom anglais « Heat Exchange Method ») ou de type Bridgman qui permet de cristalliser une charge de silicium dans un creuset avec un gradient de température axial contrôlé assurant ainsi une croissance colonnaire.

La cristallisation commence généralement par une germination de petits cristaux qui germinent à partir du fond du creuset et, lors de l'établissement d'un régime stationnaire en front plan, se poursuit par la croissance de grains colonnaires plus gros.

Habituellement, on distingue trois sortes de silicium élémentaire en fonction de leurs taux en impureté métallique :
- le silicium métallurgique, ayant un taux d'impuretés métalliques supérieur à 0,01%,
- le silicium de qualité solaire, ayant un taux d'impuretés métalliques compris entre 0,01 % et 0,000 001 %,
- et le silicium microélectronique, ayant un taux d'impuretés métalliques inférieur à 0,000 001%.

Par ailleurs, on entend souvent par silicium de qualité solaire (SoG-Si pour « Solar Grade Silicon ») la matière avant la cristallisation définitive, et par silicium photovoltaïque (PV) la matière après la cristallisation définitive du solide destiné à former les cellules photovoltaïques.

La matière première utilisée pour la cristallisation de silicium de qualité solaire provient souvent des déchets de la microélectronique ayant alors une pureté bien supérieure à la pureté requise pour les applications photovoltaïques. Face à la pénurie actuelle des déchets de silicium microélectronique et face à l'augmentation croissante de la demande de silicium de qualité solaire ou photovoltaïque, on cherche des solutions de purification de silicium métallurgique moins coûteuses et plus simples que les voies gazeuses utilisées actuellement.

Le document WO03/014019 propose un procédé de purification par traitement plasma puis par ségrégation en lingotière. Toutefois, même en poussant le procédé de purification par ségrégation à l'extrême, ce procédé permet d'abaisser le taux d'impureté métallique seulement d'un facteur 25 alors qu'on peut envisager une réduction nettement plus importante compte tenu des coefficients de partage dans le silicium, d'environ 10⁻⁵ pour le Fer et de 10⁻⁴ pour la majorité des autres impuretés métalliques.

Une solution adoptée dans le procédé PHOTOSIL®, décrit dans le document FR2831881, est de purifier le silicium métallurgique par voie liquide par trois étapes successives. La première consiste à fondre le silicium puis à le couler dans une lingotière pour ségréger rapidement les impuretés (en particulier métalliques). La deuxième étape de purification est effectuée par traitement plasma sur bain liquide pour obtenir un silicium de qualité solaire (SoG-Si). Enfin, la dernière étape est la cristallisation-ségrégation du silicium en lingot multi-cristallin de qualité photovoltaïque (PV). Cependant, l'étape de cristallisation connaît elle aussi des limites de purification (facteur 100 environ) malgré le bon contrôle des conditions thermiques dans un four de cristallisation.

Le document GB 2084978 décrit un procédé de purification de silicium qui utilise un germe et une interface solide/liquide hémisphérique.

Par ailleurs, le document EP 0748884 décrit un système de contrôle de température adapté à une cristallisation à partir d'un germe mono-cristallin, afin d'augmenter la répétabilité de la croissance du silicium avec d'excellentes propriétés cristallographiques.

### Objet de l'invention

L'objet de l'invention consiste à proposer un procédé simple permettant de purifier du silicium métallurgique afin d'obtenir du silicium de qualité solaire ou photovoltaïque ayant une bonne pureté.

Selon l'invention, ce but est atteint par les revendications annexées et, plus particulièrement, par le fait que le procédé comporte une étape de cristallisation utilisant au moins un germe de silicium, ayant de préférence une pureté de qualité au moins solaire de silicium tapissant le fond du creuset.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

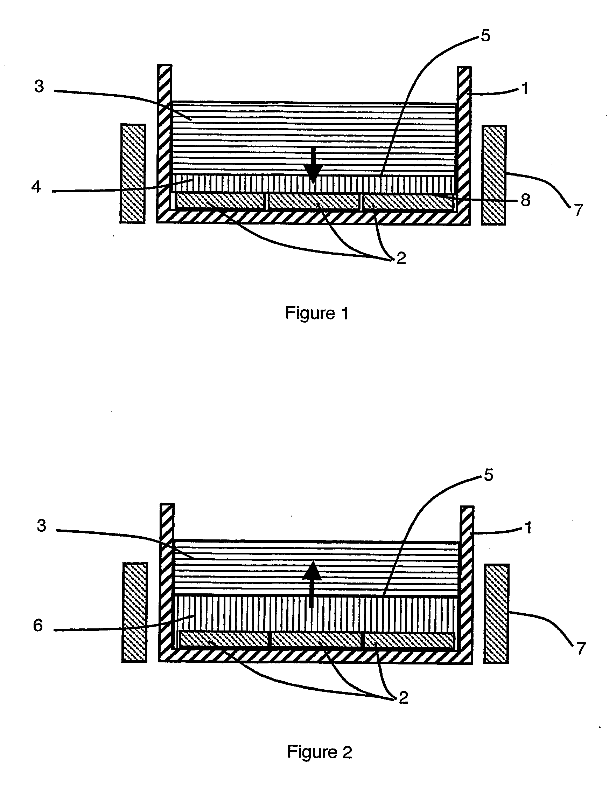

- les figures 1 et 2 représentent respectivement deux étapes d'un mode de réalisation particulier du procédé selon l'invention.

### Description d'un mode préférentiel de l'invention

La figure 1 représente un creuset 1 de purification de silicium métallurgique par solidification dirigée pour obtenir un silicium de qualité solaire ou photovoltaïque ayant une pureté prédéterminée. Lors d'une étape de cristallisation, on utilise au moins un germe 2 de silicium, ayant de préférence une pureté de qualité au moins solaire.

Le germe de silicium a, par exemple, une pureté de qualité solaire ou photovoltaïque (ayant un taux d'impuretés métalliques compris entre 0,01% et 0,000 001 %), voire une pureté de qualité microélectronique (ayant un taux d'impuretés métalliques inférieur à 0,000 001 %). On peut notamment utiliser un germe 2 de qualité solaire ou photovoltaïque ayant un taux d'impuretés métalliques inférieur à 0,01 %, par exemple de 0,0001 %.

Le germe 2 de silicium a, idéalement, une pureté supérieure ou sensiblement égale à la pureté prédéterminée du silicium de qualité solaire que l'on souhaite obtenir.

Sur les figures 1 et 2, par exemple, trois germes 2 sont utilisés. Les germes 2 sur les figures 1 et 2 sont constitués par des plaquettes de silicium et disposés sur le fond du creuset 1.

Sur la figure 1, le creuset est chargé avec du silicium métallurgique 3 qui est, de préférence, disposé sur une couche intermédiaire 4 de silicium de qualité au moins métallurgique solide. La couche intermédiaire 4 est disposée sur les germes 2 de silicium. La charge de silicium métallurgique 3 peut être disposée sous forme liquide ou solide dans le creuset 1.

Lorsque le creuset 1 est fortement chauffé par le haut, un front 5 de séparation entre une phase liquide supérieure et une phase solide inférieure descend en direction du fond du creuset 1, de manière à ce que la couche intermédiaire 4 fonde progressivement, comme illustré à la figure 1.

Lorsque la charge de silicium métallurgique 3 (et lorsqu'elle est présente la couche intermédiaire 4) est complètement fondue, le germe 2 commence à fondre. On augmente alors la puissance de refroidissement par le bas du creuset, de manière à ce que le front 5 de séparation entre les phases liquide et solide s'arrête dans la partie supérieure du germe 2 et monte progressivement vers le haut du creuset 1, comme illustré à la figure 2. La phase solide se cristallisant dans la partie inférieure du creuset 1 est ainsi du silicium de qualité solaire 6 ou photovoltaïque.

La purification est réalisée lors de la cristallisation grâce à l'utilisation du germe 2 de silicium de qualité solaire ou photovoltaïque ou microélectronique qui tapisse le fond du creuset 1. L'avantage de l'utilisation du germe 2 de silicium, et notamment de qualité au moins solaire, est de permettre une bonne ségrégation du silicium métallurgique 3. En effet, en l'absence de germe sur tout le fond du creuset, une phase transitoire de germination hétérogène initiée à partir du fond du creuset 1 ou du fond d'une lingotière, provoque la formation d'un front de solidification déstabilisé, ce qui est nocif pour la pureté du lingot obtenu, même si la solidification stationnaire ultérieure est réalisée dans des conditions idéales, c'est-à-dire par exemple avec un front plan, une vitesse de croissance lente et un brassage efficace du bain. Cette limitation a une double cause : la solidification dendritique du liquide surfondu entraîne l'incorporation d'un liquide riche en impuretés, dans la matrice de silicium solide formé. Ensuite, la migration de ce liquide dans le gradient de température provoque la remontée des impuretés dans le solide formé ultérieurement.

Par l'intermédiaire du germe 2 de silicium de qualité au moins solaire, on obtient des taux de purification bien meilleurs (proches des valeurs attendues théoriquement) que ceux actuellement obtenus lors de ségrégations en lingotière ou lors des cristallisations sans germe. Un autre avantage est de pouvoir réaliser en une seule étape les opérations de ségrégation et de cristallisation, voire de supprimer les étapes préliminaires de ségrégation. Enfin, l'utilisation du germe 2 de silicium de qualité au moins solaire augmente l'état de cristallinité du lingot obtenu, tout en offrant une plus grande souplesse dans le choix des conditions thermiques de la croissance.

Le germe 2 utilisé peut être multicristallin ou monocristallin et de pureté supérieure ou sensiblement égale à la pureté désirée dans le lingot. Il peut être issu d'une précédente cristallisation, ou, pour la première fusion, constitué de plaquettes de silicium multicristallines ou monocristallines selon que l'on désire ou non orienter les grains du lingot formé. En effet, on peut effectuer une orientation cristallographique du silicium de qualité solaire ou photovoltaïque destiné à être formé par utilisation d'un germe 2 monocristallin, ou multicristallin texturé (c'est-à-dire avec des grains présentant une orientation cristallographique préférentielle dans la direction de solidification).

Vu les grandes tailles des creusets 1 de cristallisation, plusieurs germes 2 rectangulaires, ou carrés, sont disposés côte à côte pour tapisser le fond du creuset 1 en limitant les espaces entre deux germes 2. Cependant, un unique germe massif peut aussi être utilisé pour tapisser tout le fond du creuset 1. Par ailleurs, il n'est pas nécessaire que le ou les germes atteignent strictement les parois verticales car cette zone sera écroutée par la suite. L'état de cristallinité du germe 2 n'a d'importance que pour la qualité cristalline. Avantageusement, si un pavage est utilisé, il suffit qu'il soit suffisamment jointif pour que le liquide en fusion ne coule pas entre les germe et atteigne le fond du creuset. Un pavage obtenu avec des germes ayant 1 cm d'épaisseur et espacés de 1mm peut être utilisé car la solidification a lieu avant que le liquide n'atteigne le fond du creuset. Avantageusement, il est possible de prévoir les espacements des germes au niveau des futurs zones de découpe du lingot afin d'éviter de polluer les zones utiles du lingot. Par ailleurs, l'association avec une solidification unidirectionnelle permet une remontée verticale des impuretés qui limite la pollution de la zone centrale utile du lingot.

La charge de silicium métallurgique 3 a une pureté de type métallurgique, soit extraite directement des fours de réduction de silice, soit déjà purifiée par un traitement plasma ou un affinage par exemple. La charge peut être disposée directement sur du germe 2 si la hauteur du germe 2 et la maîtrise des conditions thermiques le permettent. La charge peut aussi, comme décrit ci-dessus, être superposée à la couche intermédiaire 4 de silicium de qualité métallurgique équivalente à celle de la charge. La couche intermédiaire 4, destinée à être fondue, peut être issue d'une solidification rapide effectuée en lingotière. L'avantage de la couche intermédiaire 4 est d'empêcher la fusion du germe 2 et, ainsi, de servir de tampon thermique. On obtient alors une mise en contact entre le germe 2 et le silicium liquide, moins brutale que sans couche intermédiaire 4 et de façon homogène sur toute la surface du germe 2. De plus, la couche intermédiaire 4 facilite la mise en place de plusieurs germes 2 côte à côte en les maintenant mécaniquement. Ceci permet de réaliser une croissance sur germe avec un front 5 montant plan (figure 2) dès le début de la solidification, indispensable pour la ségrégation et la cristallisation. La couche intermédiaire 4 devient particulièrement avantageuse dans un procédé utilisant une coulée du silicium fondu sur le germe 2 pour éviter la détérioration du germe sous l'effet du choc thermique.

Il est possible d'insérer un espace supplémentaire entre le germe 2 et la couche intermédiaire 4 et de séparer la couche intermédiaire 4 et le germe 2 par un écart prédéterminé, ce qui permet de mieux contrôler la mise en contact du germe 2 avec le silicium liquide. L'écart prédéterminé peut, par exemple, être obtenu par l'intermédiaire d'une forte rugosité d'une face arrière 8 de la couche intermédiaire 4 disposée en regard du germe 2.

Une simple mesure de température réalisée au fond du creuset 1, c'est-à-dire au niveau du germe 2, permet de détecter un saut de température lorsque le silicium liquide entre en contact avec le germe 2. Lors de la détection d'un tel accroissement de température au niveau du germe 2, l'augmentation d'une puissance de refroidissement en bas du creuset 1 permet d'inverser la direction du front 5 de séparation de phases et d'initier la cristallisation. L'utilisation d'une couche intermédiaire 4, associée à la procédure ci-dessus, permet donc de minimiser l'épaisseur de germe 2 nécessaire tout en lui conservant sa qualité cristalline.

Dans la configuration en front de solidification plan, une bonne ségrégation est aussi favorisée par une convection efficace du bain de silicium. La convection peut être amplifiée soit en complétant l'apport de chaleur de la surface supérieure par des apports latéraux, soit en y ajoutant une convection forcée, par exemple par l'intermédiaire d'un champ magnétique alternatif, tournant, ou glissant.

L'extraction de chaleur est, de préférence, effectuée par la mise en contact direct de la face inférieure du germe avec une sole conductrice thermique, par opposition aux procédés classiques où le silicium est séparé de la sole de refroidissement par un fond de creuset isolant en silice. La sole est mise en contact avec un circuit de refroidissement par l'intermédiaire d'une interface ayant un coefficient d'échange de valeur prédéterminée. Cette configuration offre la possibilité de réaliser des flux d'extraction de chaleur supérieurs aux procédés classiques, utilisant un creuset en silice. On obtient ainsi un gradient de température supérieur dans le liquide et/ou une vitesse de solidification plus élevée et/ou une hauteur de lingot cristallisé plus grande, ce qui permet d'augmenter la productivité tout en assurant la stabilité morphologique du front de solidification. Le flux de chaleur est rendu quasi-unidirectionnel et les isothermes dans le silicium solide 6 quasi-planes, grâce à une température uniforme du circuit de refroidissement, un coefficient d'échange uniforme et par l'intermédiaire d'écrans thermiques latéraux 7 représentés aux figures 1 et 2. Une croissance colonnaire est ainsi assurée et les contraintes thermo-mécaniques dans le solide 6 refroidi sont minimisées.

L'idéal est de travailler dans un four de type Bridgman avec un chauffage fixe, par le haut et les côtés, et un déplacement du lingot vers le bas, à la même vitesse que le front de solidification. Une telle configuration permet d'une part d'obtenir une bonne convection dans la partie liquide (ce qui permet de ségréger et de ne pas déstabiliser le front 5 au niveau microscopique) et d'autre part d'assurer des isothermes planes dans le silicium solide 6.

La vitesse du front 5 lors de la solidification et le gradient de température, déterminé par la chaleur extraite, sont optimisés de la façon suivante : Pour les conditions de convection effectivement réalisées dans le creuset 1, on détermine par essai la vitesse maximale de solidification compatible avec la ségrégation désirée. Le gradient de température est ensuite choisi suffisamment élevé pour assurer la stabilité morphologique du front 5 à la vitesse de solidification choisie et pour la composition donnée de la charge de silicium métallurgique.

À titre d'exemple, le chauffage du bain dans un four de type Bridgman est réalisé par des éléments chauffants placés au-dessus et sur les côtés du silicium fondu. Le flux de chaleur latéral induit un mouvement de convection naturelle dans le bain, descendant sur l'axe et remontant à la périphérie. L'extraction de chaleur est réalisée en mettant le germe en contact direct avec une sole conductrice en graphite. L'extraction est déterminée au début par le rayonnement du graphite dans l'enceinte refroidie, puis par l'échange convectif avec l'atmosphère à plus basse température. Le germe 2 utilisé est, de préférence, une plaque de silicium multicristalline d'épaisseur typique de 1 cm, extraite par exemple d'un lingot utilisé pour fabriquer des cellules photovoltaïques. Une couche intermédiaire 4 d'une épaisseur typique de 1 cm est issue d'une ségrégation préalable par coulée en lingotière.

Dans un deuxième exemple, le chauffage du bain dans un four de type HEM, est réalisé à l'aide d'un système de chauffage par induction. Initialement, le silicium est chauffé par l'intermédiaire d'un suscepteur en graphite placé au-dessus. Dès que le silicium commence à fondre, le couplage électromagnétique direct sur le silicium complète le chauffage et entraîne un brassage additionnel du liquide. L'extraction de chaleur est réalisée en mettant la sole conductrice au contact d'un système de refroidissement permettant d'évacuer typiquement 100kW/m². Le germe 2 utilisé est composé de plusieurs plaques de silicium multicristallin, découpées dans des lingots élaborés précédemment par cristallisation directionnelle sans germe. Une couche intermédiaire 4 est issue d'une ségrégation préalable par coulée en lingotière.

## Revendications

1. Procédé de purification de silicium métallurgique (3) par solidification dirigée pour obtenir un silicium de qualité solaire ou photovoltaïque (6), procédé **caractérisé en ce qu'**il comporte une étape de cristallisation utilisant au moins un germe (2) de silicium tapissant le fond du creuset.

2. Procédé selon la revendication 1, **caractérisé en ce que** le germe (2) de silicium a une pureté de qualité au moins solaire.

3. Procédé selon la revendication 2, **caractérisé en ce que** le germe (2) de silicium a une pureté de qualité microélectronique.

4. Procédé selon la revendication 2, **caractérisé en ce que** le germe (2) de silicium a une pureté de qualité solaire ou photovoltaïque.

5. Procédé selon l'une quelconque des revendications 1 à 4, **caractérisé en ce que**, le silicium de qualité solaire ou photovoltaïque (6) ayant une pureté prédéterminée, le germe (2) de silicium a une pureté au moins égale à la pureté prédéterminée du silicium de qualité solaire ou photovoltaïque (6).

6. Procédé selon la revendication 5, **caractérisé en ce que** le germe (2) de silicium a une pureté sensiblement égale à la pureté prédéterminée du silicium de qualité solaire ou photovoltaïque (6).

7. Procédé selon l'une quelconque des revendications 1 à 6, **caractérisé en ce que** le germe (2) de silicium est issu d'une précédente cristallisation.

8. Procédé selon l'une quelconque des revendications 1 à 7, **caractérisé en ce que** le germe (2) de silicium est constitué par une plaquette de silicium.

9. Procédé selon l'une quelconque des revendications 1 à 8, **caractérisé en ce qu'**il comporte l'utilisation d'un germe (2) monocristallin ou multicristallin texturé.

10. Procédé selon l'une quelconque des revendications 1 à 9, **caractérisé en ce que** plusieurs germes (2) rectangulaires sont disposés côte à côte.

11. Procédé selon l'une quelconque des revendications 1 à 10, **caractérisé en ce qu'**une couche intermédiaire (4) de silicium de qualité au moins métallurgique solide est disposée sur le germe (2) de silicium et une charge de silicium métallurgique (3) est disposée sur la couche intermédiaire (4).

12. Procédé selon la revendication 11, **caractérisé en ce que** la couche intermédiaire (4) et le germe (2) sont séparés par un écart prédéterminé.

13. Procédé selon la revendication 12, **caractérisé en ce que** l'écart prédéterminé est obtenu par l'intermédiaire d'une forte rugosité d'une face de la couche intermédiaire (4) disposée en regard du germe (2).

14. Procédé selon l'une quelconque des revendications 1 à 13, **caractérisé en ce qu'**il comporte la mesure de la température au niveau du germe (2) et, lors de la détection d'un accroissement de température au niveau du germe (2), l'augmentation d'une puissance de refroidissement de manière à initier la cristallisation.

15. Procédé selon l'une quelconque des revendications 1 à 14, **caractérisé en ce qu'**une face inférieure du germe (2) est mise en contact direct avec une sole conductrice thermique.

## Patentansprüche

1. Verfahren zur Reinigung von metallurgischem Silizium (3) durch gerichtete Erstarrung, um ein Silizium von Solar- oder Photovoltaikqualität (6) zu erhalten, **dadurch gekennzeichnet, dass** das Verfahren einen Kristallisationsschritt unter Verwendung von mindestens einem Siliziumkeim (2) umfasst, der den Boden des Schmelztiegels bedeckt.

2. Verfahren gemäß Anspruch 1, **dadurch gekennzeichnet, dass** der Siliziumkeim (2) eine Reinheit von mindestens Solarqualität aufweist.

3. Verfahren gemäß Anspruch 2, dadurch gekennzeichet, dass der Siliziumkeim (2) eine Reinheit von mikroelektronischer Qualität aufweist.

4. Verfahren gemäß Anspruch 2, **dadurch gekennzeichnet, dass** der Siliziumkeim (2) eine Reinheit von Solar- oder Photovoltaikqualität aufweist.

5. Verfahren gemäß einem der Ansprüche 1 bis 4, **dadurch gekennzeichnet, dass**, wenn das Silizium von Solar- oder Photovoltaikqualität (6) eine vorgegebene Reinheit aufweist, der Siliziumkeim (2) eine Reinheit aufweist, die mindestens gleich der vorgegebenen Reinheit des Siliziums von Solar- oder Photovoltaikqualität (6) ist.

6. Verfahren gemäß Anspruch 5, **dadurch gekennzeichnet, dass** der Siliziumkeim (2) eine Reinheit aufweist, die im Wesentlichen gleich der vorgegebenen Reinheit des Siliziums von Solar- oder Photovoltaikqualität (6) ist.

7. Verfahren gemäß einem der Ansprüche 1 bis 6, **dadurch gekennzeichnet, dass** der Siliziumkeim (2) durch eine vorhergehende Kristallisation entstanden ist.

8. Verfahren gemäß einem der Ansprüche 1 bis 7, **dadurch gekennzeichnet, dass** der Siliziumkeim (2) aus einem Siliziumplättchen besteht.

9. Verfahren gemäß einem der Ansprüche 1 bis 8, **dadurch gekennzeichnet, dass** es die Verwendung eines texturierten, monokristallinen oder multikristallinen Keims (2) umfasst.

10. Verfahren gemäß einem der Ansprüche 1 bis 9, **dadurch gekennzeichnet, dass** mehrere rechteckige Keime (2) Kopf an Kopf angeordnet sind.

11. Verfahren gemäß einem der Ansprüche 1 bis 10, **dadurch gekennzeichnet, dass** eine Zwischenschicht (4) aus Silizium von mindestens metallurgischer fester Qualität auf dem Siliziumkeim (2) angeordnet ist und eine Füllung von metallurgischem Silizium (3) ist auf der Zwischenschicht (4) angeordnet.

12. Verfahren gemäß Anspruch 11, **dadurch gekennzeichnet, dass** die Zwischenschicht (4) und der Keim (2) durch einen vorgegebenen Abstand getrennt sind.

13. Verfahren gemäß Anspruch 12, **dadurch gekennzeichnet, dass** der vorgegebene Abstand mittels einer starken Rauheit einer Seite der Zwischenschicht (4) erzielt wird, die gegenüber dem Keim (2) angeordnet ist.

14. Verfahren gemäß einem der Ansprüche 1 bis 13, **dadurch gekennzeichnet, dass** es die Temperaturmessung hinsichtlich des Keims (2) sowie, bei der Erfassung eines Temperaturanstiegs hinsichtlich des Keims (2), die Erhöhung einer Kühlleistung umfasst, um die Kristallisation einzuleiten.

15. Verfahren gemäß einem der Ansprüche 1 bis 14, **dadurch gekennzeichnet, dass** eine Unterseite des Keims (2) direkt in Anlage mit einer thermischen Leitsohle gebracht wird.

## Claims

1. A method for purifying metallurgical-grade silicon (3) by directed solidification so as to obtain solar-grade or photovoltaic-grade silicon (6), method **characterized in that** it comprises a crystallisation step using a silicon seed (2) covering a bottom of the crucible.

2. The method according to claim 1, **characterized in that** the silicon seed (2) has a purity of at least solar grade.

3. The method according to claim 2, **characterized in that** the silicon seed (2) has a microelectronic-grade purity.

4. The method according to claim 2, **characterized in that** the silicon seed (2) has a solar- or photovoltaic-grade purity.

5. The method according to any one of claims 1 to 4, **characterized in that**, the solar- or photovoltaic-grade silicon (6) having a predetermined purity, the silicon seed (2) has a purity at least equal to the predetermined purity of the solar- or photovoltaic-grade silicon (6).

6. The method according to claim 5, **characterized in that** the silicon seed (2) has a purity substantially equal to the purity of the solar- or photovoltaic-grade silicon (6).

7. The method according to any one of claims 1 to 6, **characterized in that** the silicon seed (2) comes from a previous crystallization.

8. The method according to any one of claims 1 to 7, **characterized in that** the silicon seed (2) is formed by a silicon wafer.

9. The method according to any one of claims 1 to 8, **characterized in that** it comprises the use of a single-crystal or textured multi-crystal seed (2).

10. The method according to any one of claims 1 to 9, **characterized in that** several rectangular seeds (2) are arranged side by side.

11. The method according to any one of claims 1 to 10, **characterized in that** an intermediate layer (4) of solid silicon of at least metallurgical grade is arranged on the seed silicon (2) and a metallurgical silicon feedstock (3) is arranged on the intermediate layer (4).

12. The method according to claim 11, **characterized in that** the intermediate layer (4) and the seed (2) are separated by a predetermined gap.

13. The method according to claim 12, **characterized in that** the predetermined gap is obtained by means of a large roughness of a surface of the intermediate layer (4) arranged facing the seed (2).

14. The method according to any one of claims 1 to 13, **characterized in that** it comprises temperature measurement at the level of the seed (2) and, when a temperature increase is detected at the level of the seed (2), increase of the cooling power so as to initiate crystallization.

15. The method according to any one of claims 1 to 14, **characterized in that** a bottom surface of the seed (2) is placed in direct contact with a heat-conducting sole.
